# EUROPEAN PATENT APPLICATION

(11) **EP 4 312 255 A1**
(43) Date of publication of application: **31.01.2024**
(21) Application number: 23188108.7
(22) Date of filing: 27.07.2023
(51) Int. Cl.: H01L 23/00, H01L 21/78

(54) **SEMICONDUCTOR DEVICE AND MANUFACTURING METHOD OF SEMICONDUCTOR DEVICE**

(30) Priority: 29.07.2022 JP 2022121410
(71) Applicant: Mitsuboshi Diamond Industrial Co., Ltd., Settsu, Osaka 566-0034 (JP)
(72) Inventor: KUMAZAWA, Teruaki, Nisshin-shi, 470-0111 (JP); UECHA, Masashi, Nisshin-shi, 470-0111 (JP); NAGUMO, Yuji, Nisshin-shi, 470-0111 (JP); OKUDA, Masaru, Nisshin-shi, 470-0111 (JP); NAGAYA, Masatake, Nisshin-shi, 470-0111 (JP); KITAICHI, Mitsuru, Settsu-city, 566-0034 (JP); MORI, Akira, Settsu-city, 566-0034 (JP); KIYAMA, Naoya, Settsu-city, 566-0034 (JP); TAKEDA, Masakazu, Settsu-city, 566-0034 (JP)
(74) Representative: TBK

(57) **Abstract**

A semiconductor device (10) includes a semiconductor substrate (12) and a metal layer (20) disposed on a surface (12a) of the semiconductor substrate. The metal layer includes a first metal layer (22, 24) and a second metal layer (26). The second metal layer covers a surface of the first metal layer and has a higher solder wettability than the first metal layer. The second metal layer is exposed on a main surface (20a) of the metal layer. The first metal layer is exposed on a side surface (20b) of the metal layer. The metal layer has a protruding portion (30) on the main surface. The protruding portion extends to make one round along an outer peripheral edge of the main surface.

## Description

The present disclosure relates to a semiconductor device and a manufacturing method of a semiconductor device.

JP 2004-241623 A discloses a semiconductor device that includes a semiconductor substrate having a metal layer formed on a rear surface thereof. The metal layer is soldered to a package substrate.

In general, a metal having a high solder wettability is used as a material of a metal layer that is used when a semiconductor substrate is soldered. Therefore, in the technique disclosed in JP 2004-241623 A, when the metal layer is soldered to the package substrate, solder wets and spreads toward a side surface (that is, an outer peripheral surface) of the metal layer, and the solder may reach the side surface of the semiconductor substrate. As a result, characteristics of the semiconductor device may vary. The present disclosure proposes a technique for suitably restricting unnecessary wetting and spreading of solder when a semiconductor substrate is soldered.

A semiconductor device according to a first aspect of the present disclosure includes a semiconductor substrate and a metal layer disposed on a surface of the semiconductor substrate. The metal layer includes a first metal layer and a second metal layer. The second metal layer covers a surface of the first metal layer and has a higher solder wettability than the first metal layer. The second metal layer is exposed on a main surface of the metal layer. The first metal layer is exposed on a side surface of the metal layer. The metal layer has a protruding portion on the main surface. The protruding portion extends to make one round along an outer peripheral edge of the main surface.

In the semiconductor device according to the first aspect, the second metal layer having the higher solder wettability is exposed on the main surface of the metal layer. Therefore, when the metal layer is soldered to a target member, solder suitably wets and spreads on the main surface of the metal layer. On the other hand, the main surface of the metal layer is provided with the protruding portion that extends to make one round along the outer peripheral edge of the main surface. Therefore, when the metal layer is soldered to the target member, the solder is blocked by the protruding portion, and the solder is restricted from wetting and spreading to an outer peripheral side of the metal layer. Furthermore, in the semiconductor device, the first metal layer is exposed on the side surface of the metal layer. Therefore, even if the solder passes over the protruding portion, since the first metal layer having a lower solder wettability is exposed on the side surface of the metal layer, the solder is less likely to wet and spread on the side surface of the metal layer, and the solder is restricted from reaching the side surface of the semiconductor substrate. As described above, the semiconductor device according to the first aspect can restrict unnecessary wetting and spreading of the solder while ensuring the wettability of the solder.

In a manufacturing method of a semiconductor device according to a second aspect of the present disclosure, a semiconductor wafer having a first surface and a second surface located opposite the first surface is prepared. The semiconductor wafer has a metal layer formed on the first surface. The metal layer includes a first metal layer and a second metal layer. The second metal layer covers a surface of the first metal layer and is exposed on a main surface of the metal layer. A pressing member is pressed against the main surface of the metal layer along a planned dividing line to deform the metal layer along the planned dividing line, to form a groove extending along the planned dividing line and a protruding portion extending adjacent to the groove, and to form a crack extending in a thickness direction of the semiconductor wafer along the planned dividing line. After the forming of the crack, a dividing member is pressed against the second surface of the semiconductor wafer along the planned dividing line to divide the semiconductor wafer along the planned dividing line.

In the manufacturing method according to the second aspect, the pressing member is pressed against the main surface of the metal layer, which is formed on the first surface of the semiconductor wafer, along the planned dividing line. By pressing the pressing member, the crack is formed in a portion of the semiconductor wafer close to the first surface. In addition, by pressing the pressing member against the metal layer, the metal layer is plastically deformed to form the groove, and the metal layer is pushed out to a range adjacent to the planned dividing line by an amount of the pressing member biting into the metal layer. Accordingly, the protruding portion extending adjacent to the groove is formed. Thereafter, the dividing member is pressed against the semiconductor wafer from a direction facing the second surface along the planned dividing line. Accordingly, the crack is spread, and a force is applied in a direction of separating the adjacent regions across the crack. As a result, the crack extends in the thickness direction of the semiconductor wafer. Accordingly, the semiconductor wafer is divided along the planned dividing line. In addition, a force is also applied to the metal layer in a direction of separating adjacent regions across the crack, and the metal layer is also divided.

As described above, in the manufacturing method according to the second aspect, when the crack is formed, the protruding portion extending adjacent to the planned dividing line (that is, the groove) is formed. Thus, when the semiconductor wafer and the metal layer are divided along the planned dividing line, the main surface of the divided metal layer is provided with the protruding portion that extends to make one round along the outer peripheral edge of the main surface. Therefore, in the semiconductor device manufactured by the manufacturing method, when the metal layer is soldered to a target member, solder is blocked by the protruding portion, and the solder is restricted from wetting and spreading to the outer peripheral side of the metal layer. In addition, the metal layer includes two layers of the first metal layer and the second metal layer, and the first metal layer having a lower solder wettability is exposed on the side surface of the divided metal layer. Therefore, in the semiconductor device manufactured by the manufacturing method, even if the solder passes over the protruding portion, the solder is less likely to wet and spread on the side surface of the metal layer, and the solder is restricted from reaching the side surface of the semiconductor substrate. As described above, the semiconductor device manufactured by the manufacturing method according to the second aspect can restrict unnecessary wetting and spreading of the solder while securing the wettability.

In the present disclosure, "solder" has a comprehensive meaning including, for example, a conductive bonding agent utilizing dispersion and precipitation of metal fine particles in a dispersion medium (an organic solvent or the like) in addition to a bonding agent utilizing a melting point (melting and solidification) of metal containing metal such as tin as a main component.

Additional objects and advantages of the present disclosure will be more readily apparent from the following detailed description when taken together with the accompanying drawings. In the drawings:
FIG. 1 is a cross-sectional view of a semiconductor device according to an embodiment;
FIG. 2 is a bottom view of the semiconductor device according to the embodiment;
FIG. 3 is an enlarged view of a periphery of a protruding portion of a metal layer of the semiconductor device according to the embodiment;
FIG. 4 is a diagram for explaining a state in which the semiconductor device of the embodiment is soldered;
FIG. 5 is a diagram for explaining another state in which the semiconductor device of the embodiment is soldered;
FIG. 6 is a plan view of a semiconductor wafer;
FIG. 7 is a diagram for explaining a metal layer forming process;
FIG. 8 is a diagram for explaining a crack forming process;
FIG. 9 is a diagram for explaining a protruding portion formed in the crack forming process;
FIG. 10 is a diagram for explaining a dividing process; and
FIG. 11 is a diagram illustrating multiple divided semiconductor devices.

In the semiconductor device according to the first aspect of the present disclosure, the first metal layer may be exposed with a width of 1 µm or more at an outer peripheral end of the protruding portion.

In such a configuration, when the metal layer is soldered to the target member, even if the solder passes over the protruding portion, the wetting and spreading of the solder can be more effectively restricted by the first metal layer.

In the semiconductor device according to the first aspect of the present disclosure, the protruding portion may have a height of 1/2 or more of a thickness of the metal layer.

In such a configuration, when the metal layer is soldered to the target member, it is possible to more effectively restrict the solder from wetting and spreading over the protruding portion.

In the semiconductor device according to the first aspect of the present disclosure, the side surface of the semiconductor substrate may be a cleavage plane.

In the semiconductor device according to the first aspect of the present disclosure, the first metal layer may include at least one of a nickel layer or a titanium layer, and the second metal layer may be a gold layer.

The gold layer has relatively high solder wettability, and the nickel layer and the titanium layer have relatively low solder wettability. Therefore, in this configuration, it is possible to effectively restrict unnecessary wetting and spreading of the solder while securing the wettability of the solder.

In the semiconductor device according to the first aspect of the present disclosure, the protruding portion may have undulations along the outer peripheral edge of the main surface. The protruding portion may be intermittently formed along the outer peripheral edge of the main surface.

In the manufacturing method of the semiconductor device according to the second aspect of the present disclosure, the pressing member may be a scribing wheel, the pressing of the pressing member may be rolling of the scribing wheel, and the forming of the crack may include forming, on the first surface, a scribe line with the crack extending in the thickness direction of the semiconductor wafer along the scribe line.

In the manufacturing method described above, the scribing wheel having a circular plate shape (annular shape) is rotatably and pivotally supported and rolled, so that the crack can be easily formed along the planned dividing line.

In the manufacturing method according to the second aspect of the present disclosure, the first metal layer may include at least one of a nickel layer or a titanium layer, and the second metal layer may be a gold layer.

### (Embodiment)

Hereinafter, a semiconductor device 10 of an embodiment will be described with reference to the drawings. The semiconductor device 10 of the present embodiment includes a semiconductor substrate 12 and a metal layer 20. The semiconductor substrate 12 has a first main surface 12a, a second main surface 12b located opposite to the first main surface 12a, and a side surface 12c connecting the first main surface 12a and the second main surface 12b. Although not illustrated, semiconductor elements having functions such as transistors and diodes are formed in the semiconductor substrate 12. The semiconductor substrate 12 is made of silicon carbide (SiC). The semiconductor substrate 12 may be made of another semiconductor materials such as silicon (Si) or gallium nitride (GaN). The side surface 12c of the semiconductor substrate 12 is a cleavage plane.

The metal layer 20 is disposed on the first main surface 12a of the semiconductor substrate 12. The metal layer 20 includes a titanium layer 22, a nickel layer 24, and a gold layer 26. The titanium layer 22 covers the first main surface 12a of the semiconductor substrate 12. The nickel layer 24 covers a surface of the titanium layer 22. The gold layer 26 covers a surface of the nickel layer 24. The gold layer 26 is made of gold (that is, Au). The gold layer 26 is exposed on a main surface 20a of the metal layer 20. The titanium layer 22 and the nickel layer 24 are exposed on a side surface 20b of the metal layer 20. In other words, on the side surface 20b of the metal layer 20, the titanium layer 22 and the nickel layer 24 are not covered with the gold layer 26. The titanium layer 22 has a thickness of about 200 nm, the nickel layer 24 has a thickness of about 1000 nm, and the gold layer 26 has a thickness of about 50 nm. The nickel layer 24 and the titanium layer 22 are examples of a "first metal layer", and the gold layer 26 is an example of a " second metal layer". Examples of the metal constituting the second metal layer include silver in addition to gold.

The gold layer 26 has a higher solder wettability than the nickel layer 24. A solder wettability of a metal can be evaluated by, for example, a wetting and spreading ratio of solder. The wetting and spreading ratio can be calculated by placing solder on a surface of a certain metal, melting the solder, and measuring a shape of the solder after melting (that is, after wetting and spreading). Specifically, when a height and a diameter of the solder after wetting and spreading are denoted as H and D, respectively, the wetting and spreading ratio can be calculated by 100×(D-H)/D. The wetting and spreading ratio of the gold layer 26 is about 95%, and the wetting and spreading ratio of the nickel layer 24 is about 50%.

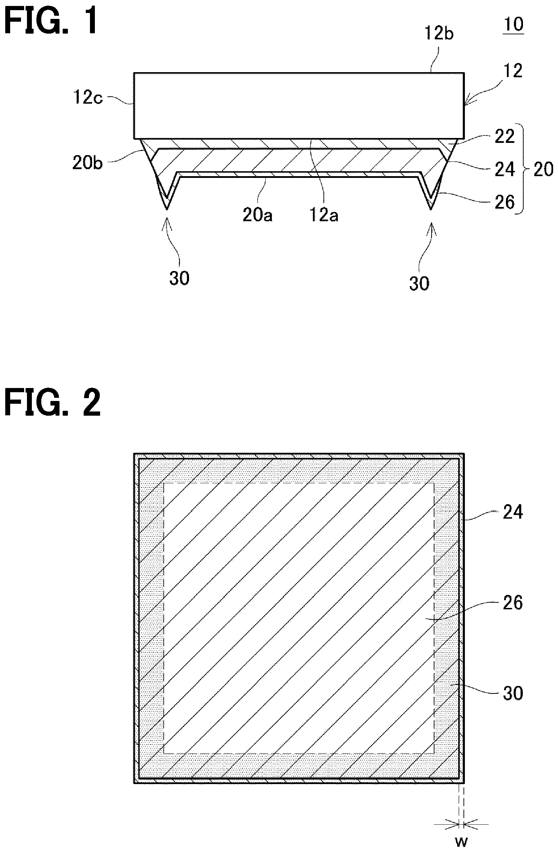

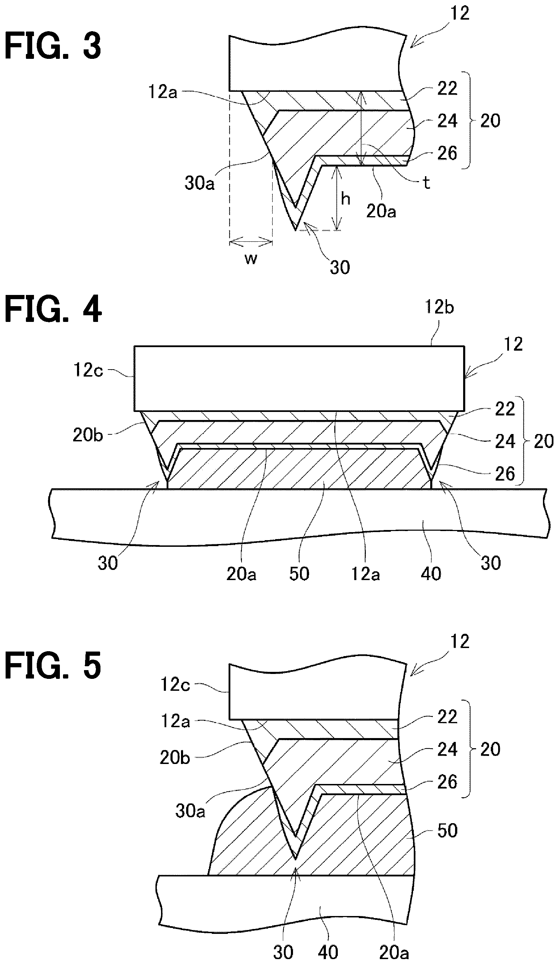

The metal layer 20 has a protruding portion 30. As indicated by dot hatching in FIG. 2, the protruding portion 30 extends to make one round along an outer peripheral edge of the main surface 20a of the metal layer 20. As shown in FIG. 3, a height h of the protruding portion 30 from the main surface 20a of the metal layer 20 is 1/2 or more of a thickness t of the metal layer 20, that is, a thickness from the first main surface 12a of the semiconductor substrate 12 to the main surface 20a of the metal layer 20. The thickness t and the height h are not particularly limited. For example, the thickness t of the metal layer 20 may be about 200 to 5000 nm and the height h of the protruding portion 30 may be about 100 to 3000 nm. The protruding portion 30 may have undulations along the outer peripheral edge of the main surface 20a, and the protruding portion 30 may be intermittently formed along the outer peripheral edge of the main surface 20a. However, it is preferable that a ratio of a portion having a thickness t of 1/2 or more of the metal layer 20 is, for example, 1/3 or more, particularly 1/2 or more, with respect to a length of the entire outer peripheral edge of the main surface 20a.

As shown in FIG. 3, the nickel layer 24 and the titanium layer 22 are also exposed at a portion 30a of an outer peripheral end of the protruding portion 30. That is, in the portion 30a, the nickel layer 24 and the titanium layer 22 are not covered with the gold layer 26. A width w of the portion 30a when the semiconductor substrate 12 is viewed from below (see also FIG. 2) is about 2 µm.

The semiconductor device 10 of the present embodiment is, for example, soldered to a conductor plate 40 such as a heat sink. FIG. 4 and FIG. 5 show a state in which the semiconductor device 10 is bonded to the conductor plate 40 with a solder 50 through the metal layer 20. As shown in FIG. 4, in the metal layer 20 of the semiconductor device 10, the gold layer 26 having the high solder wettability is exposed on the main surface 20a. Therefore, when the metal layer 20 is soldered to the conductor plate 40, the solder 50 suitably wets and spreads on the main surface 20a of the metal layer 20. On the other hand, the main surface 20a of the metal layer 20 is provided with the protruding portion 30 that extends to make one round along the outer peripheral edge of the main surface 20a. Therefore, when the metal layer 20 is soldered to the conductor plate 40, the solder 50 is blocked by the protruding portion 30, and the solder 50 is restricted from wetting and spreading to an outer peripheral side of the metal layer 20. Even when the protruding portion 30 has undulations along the outer peripheral edge of the main surface 20a or is intermittently formed, a surface tension of the solder 50 or the like also acts, and the wetting and spreading of the solder 50 to the outer peripheral side can be restricted.

In the semiconductor device 10, the nickel layer 24 and the titanium layer 22 are exposed at the portion 30a of the protruding portion 30 and the side surface 20b of the metal layer 20. Therefore, as shown in FIG. 5, even if the solder 50 passes over the protruding portion 30, since the nickel layer 24 and the titanium layer 22 having the low solder wettability are exposed, the solder 50 is less likely to wet and spread from the gold layer 26 to the nickel layer 24 and the titanium layer 22, and the solder 50 is restricted from reaching the side surface 12c of the semiconductor substrate 12. As described above, the semiconductor device 10 can restrict unnecessary wetting and spreading of the solder 50 while ensuring the wettability of the solder 50 with respect to the main surface 20a of the metal layer 20.

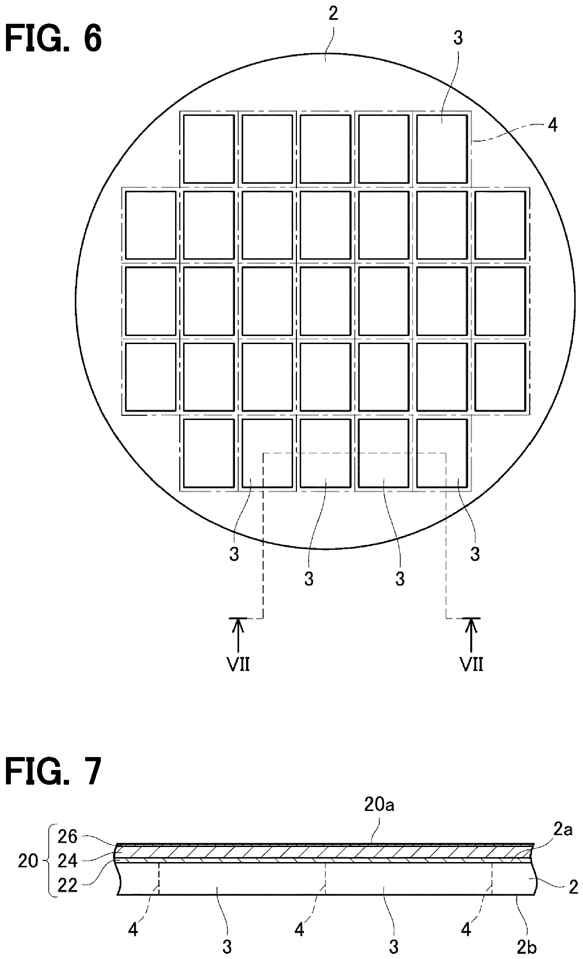

Next, a manufacturing method of the semiconductor device 10 will be described. First, a semiconductor wafer 2 shown in FIG. 6 is prepared. In the semiconductor wafer 2, multiple element regions 3 are formed in a matrix. In FIG. 6, each of the element regions 3 is schematically illustrated by a solid line. For convenience of description, division lines that are boundaries between adjacent element regions 3 and are used when the semiconductor wafer 2 is divided into individual element regions 3 are referred to as planned dividing lines 4. The planned dividing lines 4 are not actually drawn on the semiconductor wafer 2 but are virtual lines. The planned dividing lines 4 may be lines or grooves actually drawn on the semiconductor wafer 2 so as to be visible. In each of the element regions 3, a semiconductor element having a function such as a transistor or a diode is formed. The semiconductor wafer 2 is made of silicon carbide (SiC). The semiconductor wafer 2 may be made of another semiconductor material such as silicon (Si) or gallium nitride (GaN). As shown in FIG. 7 and the like, the semiconductor wafer 2 has a first surface 2a and a second surface 2b located opposite to the first surface 2a.

### <Metal Layer Forming Process>

A metal layer forming process shown in FIG. 7 is performed on the semiconductor wafer 2 shown in FIG. 6. In the metal layer forming process, the metal layer 20 is formed on the first surface 2a of the semiconductor wafer 2. The metal layer 20 includes the titanium layer 22, the nickel layer 24, and the gold layer 26 that is a layer made of gold. The titanium layer 22, the nickel layer 24, and the gold layer 26 are deposited in this order on the first surface 2a of the semiconductor wafer 2. The metal layer 20 is formed so as to cover substantially the entire region of the first surface 2a. That is, the metal layer 20 is formed on the first surface 2a so as to extend over the element regions 3. The metal layer 20 functions as an electrode of the completed semiconductor device. The thickness of the titanium layer 22 is about 200 nm, the thickness of the nickel layer 24 is about 1000 nm, and the thickness of the gold layer 26 is about 50 nm.

### <Crack Forming Process>

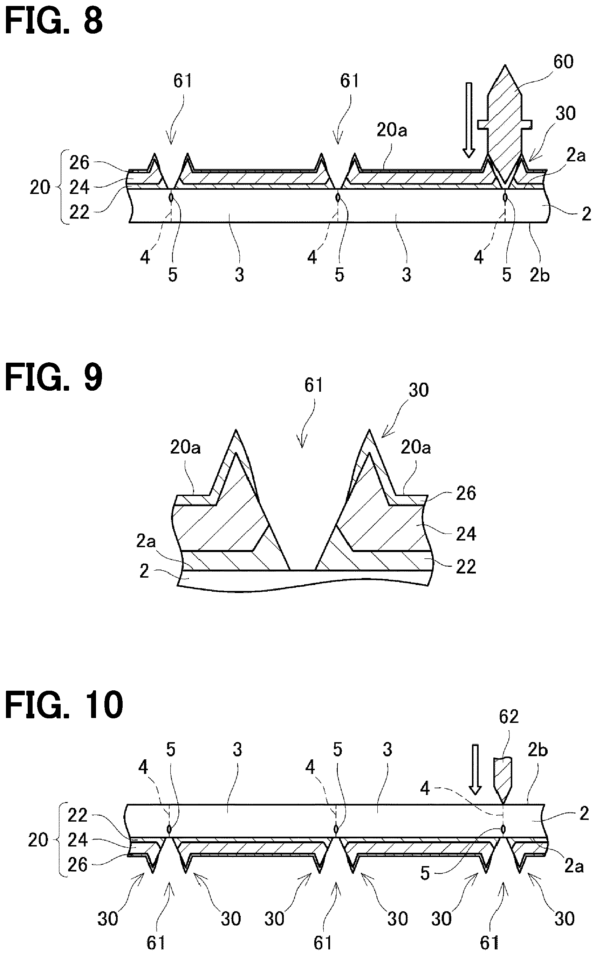

Next, a crack forming process shown in FIG. 8 is performed. In the crack forming process, a scribing wheel 60 is pressed against the main surface 20a of the metal layer 20 from a direction facing the first surface 2a of the semiconductor wafer 2 to form scribe lines 61 with cracks 5 in the semiconductor wafer 2. The scribing wheel 60 is a disk-shaped (annular) member and is rotatably supported by a support apparatus (not shown). The scribing wheel 60 is moved (scanned) along the planned dividing line 4 while being pressed against the main surface 20a of the metal layer 20. When the scribing wheel 60 is moved along the planned dividing line 4, the scribing wheel 60 rolls on the main surface 20a of the metal layer 20 like a tire rolling on a road surface.

The scribing wheel 60 has a sharp peripheral edge, and forms the scribe lines 61 in which the metal layer 20 is plastically deformed along the planned dividing lines 4 on the main surface 20a of the metal layer 20. As the scribing wheel 60, it is possible to use a scribing wheel in which a notch (groove) is formed in a peripheral edge portion or a ridge line is intermittent, instead of a scribing wheel in which a ridge line is continuously formed in the peripheral edge portion.

When the main surface 20a is pressed by the scribing wheel 60, a compressive stress is generated in a region of a surface layer of the first surface 2a inside the semiconductor wafer 2. While the scribe lines 61 (that is, the grooves) are formed at pressed portions by the scribing wheel 60, tensile stress is generated in the semiconductor wafer 2 immediately below the region where compressive stress is generated. The first surface 2a of the semiconductor wafer 2 is exposed at bottoms of the grooves that form the scribe lines 61, and the first surface 2a of the semiconductor wafer 2 is directly pressed by the scribing wheel 60.

The tensile stress is generated in a direction away from the planned dividing lines 4 along the first surface 2a of the semiconductor wafer 2 immediately below the region where the compressive stress is generated. Due to this tensile stress, the cracks 5 extending in the thickness direction of the semiconductor wafer 2 are formed inside from the first surface 2a of the semiconductor wafer 2. In the present embodiment, by moving the scribing wheel 60 along the planned dividing lines 4 while pressing the scribing wheel 60 against the main surface 20a, the metal layer 20 is divided by the scribe lines 61 along the boundaries between the adjacent element regions 3, and the cracks 5 are formed so as to extend in the thickness direction of the semiconductor wafer 2. The cracks 5 are formed in the vicinity of the surface layer of the first surface 2a of the semiconductor wafer 2. The scribing wheel 60 is an example of a pressing member.

In general, compressive stress restricts formation and extension of cracks. Thus, the cracks 5 are formed so as to extend from an outside of the region of the first surface 2a of the semiconductor wafer 2 where the compressive stress is generated by the scribing wheel 60 to the region where the tensile stress is generated directly below the region where the compressive stress is generated. Even when the first surface 2a of the semiconductor wafer 2 is not exposed at the bottoms of the grooves that form the scribe lines 61, that is, when the first surface 2a of the semiconductor wafer 2 is pressed through the metal layer 20 (for example, the titanium layer 22), the cracks 5 can be formed by controlling a pressing load by the scribing wheel 60.

As described above, the metal layer 20 is plastically deformed by being pressed by the scribing wheel 60. At this time, the metal layer 20 is pushed out to a range adjacent to the planned dividing line 4 by the amount of the scribing wheel 60 biting into the main surface 20a (that is, the volume of the scribe line 61 to be formed), and the entire or most part of the metal layer 20 is divided. Accordingly, the protruding portion 30 is formed on the main surface 20a of the metal layer 20 so as to extend adjacent to both sides of the planned dividing line 4.

The thickness of the gold layer 26 is extremely smaller than the thicknesses of the nickel layer 24 and the titanium layer 22. Therefore, as shown in FIG. 9, at a side wall portion of the scribe line 61, the gold layer 26 is pushed laterally by the scribing wheel 60, the exposed nickel layer 24 is also pushed laterally, the exposed titanium layer 22 is also pushed laterally, and the first surface 2a of the semiconductor wafer 2 is exposed on the bottom portion of the scribe line 61. For example, in a case where a scribing wheel in which a notch (groove) is formed in a peripheral edge portion or a ridgeline is intermittent is used as the scribing wheel 60, it is possible to form the protruding portion 30 having undulations or the protruding portion 30 that is intermittently continuous.

### <Dividing Process>

Next, a dividing process shown in FIG. 10 is performed. It should be noted that, in FIG. 10, the semiconductor wafer 2 is illustrated is such a manner that the second surface 2b faces upward. In the dividing process, a breaking plate 62 is pressed along the planned dividing line 4 (that is, the crack 5 formed in the crack forming process), and the semiconductor wafer 2 is divided along the planned dividing line 4 (that is, along the boundary of the element regions 3). In the present embodiment, the breaking plate 62 is pressed against the second surface 2b of the semiconductor wafer 2. The breaking plate 62 is a plate-like member. A lower end of the breaking plate 62 (that is, an end edge pressed against the second surface 2b) has a ridgeline shape (a sharp edge shape), but is only pressed against the semiconductor wafer 2 without cutting the semiconductor wafer 2.

When the breaking plate 62 is pressed against the second surface 2b, the semiconductor wafer 2 is bent. The crack 5 is formed in the vicinity of the surface layer of the first surface 2a of the semiconductor wafer 2. Therefore, when the breaking plate 62 is pressed against the semiconductor wafer 2 from the direction facing the second surface 2b, the semiconductor wafer 2 is bent about the pressed portion (line), and, in a portion close to the first surface 2a, a force is applied to the crack 5 in a direction in which the crack 5 is spread and the two element regions 3 adjacent to the crack 5 is separated. As described above, the tensile stress is applied to the periphery of the crack 5.

Therefore, when the breaking plate 62 is pressed against the second surface 2b, the crack 5 extends in the thickness direction of the semiconductor wafer 2, and the semiconductor wafer 2 is divided along the planned dividing line 4. At this time, the semiconductor wafer 2 is cleaved with the crack 5 as a starting point. In other words, the divided surface (that is, the side surface 12c shown in FIG. 1) of the semiconductor wafer 2 becomes a cleavage plane. In addition, since the metal layer 20 is divided along the scribe line 61, the semiconductor device 10 which is divided into individual pieces can be obtained by dividing the semiconductor wafer 2. Even when the metal layer 20 is not completely divided at the time of forming the scribe line 61 (that is, when the first surface 2a of the semiconductor wafer 2 is not exposed), the metal layer 20 which is not divided is formed on the first surface 2a of the semiconductor wafer 2 and is exposed on the bottom of the scribe line 61. Therefore, when the breaking plate 62 is pressed against the second surface 2b, a force is also applied to the metal layer 20 in a direction in which the two element regions 3 adjacent to the dividing position are separated, and the metal layer 20 is deformed so as to be separated and divided along the scribe line 61. The breaking plate 62 is an example of a "dividing member".

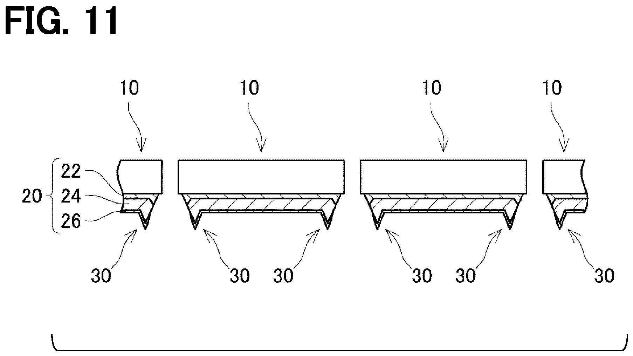

In the dividing process, the process of pressing the breaking plate 62 against the second surface 2b is repeatedly performed along each planned dividing line 4. Accordingly, the semiconductor wafer 2 and the metal layer 20 (when the metal layer 20 is not completely divided) can be divided along the boundary between the element regions 3. As a result, as shown in FIG. 11, the semiconductor wafer 2 is divided into multiple semiconductor devices 10. Accordingly, the semiconductor devices 10 with the metal films 20 (electrode) formed on the surfaces thereof are completed. As described above, on the side wall of the scribe line 61, the gold layer 26 is extruded in the vicinity of the surface of the semiconductor device 10, and the nickel layer 24 and the titanium layer 22 are exposed in the vicinity of the bottom portion of the scribe line 61. The nickel layer 24 and the titanium layer 22 are also exposed on the divided surfaces of the metal layer 20 after division. Therefore, in the metal layer 20 of the divided semiconductor device 10, the nickel layer 24 and the titanium layer 22 are exposed at the outer peripheral end.

In this manufacturing method, after the metal layer 20 including the titanium layer 22, the nickel layer 24, and the gold layer 26 is formed on the first surface 2a of the semiconductor wafer 2, the scribing wheel 60 is pressed against the main surface 20a of the metal layer 20 from a direction facing the first surface 2a along the planned dividing line 4. By pressing the scribing wheel 60, the whole or most of the metal layer 20 is divided, and the crack 5 is formed in a portion of the semiconductor wafer 2 close to the first surface 2a. In addition, by pressing the scribing wheel 60, the metal layer 20 is plastically deformed, and the metal layer 20 is pushed out to a range adjacent to the planned dividing line 4 by the amount of the scribing wheel 60 biting into the metal layer 20, and the metal layer 20 is divided.

As a result, the protruding portion 30 extending adjacent to the planned dividing line 4 is formed. Thereafter, the breaking plate 62 is pressed against the semiconductor wafer 2 from the direction facing the second surface 2b along the planned dividing line 4. Accordingly, the crack 5 is widened, and a force is applied in a direction of separating the adjacent regions across the crack 5. As a result, the crack 5 extends in the thickness direction of the semiconductor wafer 2, and the semiconductor wafer 2 is divided along the planned dividing line 4. When the metal layer 20 is not completely divided, a force is also applied to the metal layer 20 in a direction in which adjacent regions across the crack 5 are separated, and the metal layer 20 is also divided.

As described above, in the above-described manufacturing method, when the crack 5 is formed, the protruding portion 30 extending adjacent to the planned dividing line 4 is formed. Therefore, when the semiconductor wafer 2 and the remaining metal layer 20 are divided along the planned dividing line 4, the metal layer 20 after the division has the protruding portion 30 that extends to make one round along the outer peripheral edge of the main surface 20a. Therefore, in the semiconductor device 10 manufactured by this manufacturing method, when the metal layer 20 is soldered to a target member, that is, the conductor plate 40 and the like in FIG. 4 and FIG. 5, the solder is blocked by the protruding portion 30, and the solder is restricted from wetting and spreading to the outer peripheral side of the metal layer 20.

In addition, since the metal layer 20 includes the nickel layer 24, the titanium layer 22, and the gold layer 26, the metal layer 20 after the division is in a state in which the nickel layer 24 and the titanium layer 22 having low solder wettability are exposed on the side surface of the metal layer 20. Therefore, in the semiconductor device 10 manufactured by this manufacturing method, even if the solder passes over the protruding portion 30, the solder is less likely to wet and spread on the side surface of the metal layer 20 on which the nickel layer 24 and the titanium layer 22 are exposed, and the solder is restricted from reaching the side surface of the semiconductor substrate. As described above, the semiconductor device manufactured by this manufacturing method can restrict unnecessary wetting and spreading of the solder while securing the wettability.

In the embodiment described above, the metal layer 20 includes the titanium layer 22, the nickel layer 24, and the gold layer 26. However, the type of metal constituting the metal layer 20 is not particularly limited, as long as a solder wettability of a metal exposed on the main surface 20a of the metal layer 20 is higher than a solder wettability of another metal located under the metal.

Furthermore, in the embodiment described above, the nickel layer 24 does not have to be exposed at the portion 30a of the outer peripheral end of the protruding portion 30. The height h of the protruding portion 30 may be less than 1/2 of the thickness t of the metal layer 20. Even with such a configuration, unnecessary wetting and spreading of the solder can be restricted.

Although the embodiments have been described in detail above, these are merely examples and do not limit the scope of claims. The techniques described in the claims include various modifications and modifications of the specific examples illustrated above. The technical elements described in the present specification or the drawings exhibit technical usefulness alone or in various combinations, and are not limited to the combinations described in the claims at the time of filing. In addition, the techniques illustrated in the present specification or drawings achieve a plurality of objectives at the same time, and achieving one of the objectives itself has technical usefulness.

A semiconductor device (10) includes a semiconductor substrate (12) and a metal layer (20) disposed on a surface (12a) of the semiconductor substrate. The metal layer includes a first metal layer (22, 24) and a second metal layer (26). The second metal layer covers a surface of the first metal layer and has a higher solder wettability than the first metal layer. The second metal layer is exposed on a main surface (20a) of the metal layer. The first metal layer is exposed on a side surface (20b) of the metal layer. The metal layer has a protruding portion (30) on the main surface. The protruding portion extends to make one round along an outer peripheral edge of the main surface.

## Claims

1. A semiconductor device (10) comprising:
a semiconductor substrate (12); and
a metal layer (20) disposed on a surface (12a) of the semiconductor substrate, wherein
the metal layer includes a first metal layer (22, 24) and a second metal layer (26),
the second metal layer covers a surface of the first metal layer and has a higher solder wettability than the first metal layer,
the second metal layer is exposed on a main surface (20a) of the metal layer,
the first metal layer is exposed on a side surface (20b) of the metal layer,
the metal layer has a protruding portion (30) on the main surface, and
the protruding portion extends to make one round along an outer peripheral edge of the main surface.

2. The semiconductor device according to claim 1, wherein
the first metal layer is exposed at an outer peripheral end of the protruding portion with a width of 1 µm or more.

3. The semiconductor device according to claim 1 or 2, wherein
a height (h) of the protruding portion is 1/2 or more of a thickness (t) of the metal layer.

4. The semiconductor device according to any one of claims 1 to 3, wherein
a side surface (12c) of the semiconductor substrate is a cleavage plane.

5. The semiconductor device according to any one of claims 1 to 4, wherein
the first metal layer includes at least one of a nickel layer or a titanium layer, and
the second metal layer is a gold layer.

6. The semiconductor device according to any one of claims 1 to 5, wherein
the protruding portion has undulations along the outer peripheral edge of the main surface.

7. The semiconductor device according to any one of claims 1 to 5, wherein
the protruding portion is intermittently formed along the outer peripheral edge of the main surface.

8. A manufacturing method of a semiconductor device, comprising:
preparing a semiconductor wafer (2) having a first surface (2a) and a second surface (2b) located opposite to the first surface, the semiconductor wafer having a metal layer (20) formed on the first surface, the metal layer including a first metal layer (22, 24) and a second metal layer (26), the second metal layer covering a surface of the first metal layer and exposed on a main surface (20a) of the metal layer;
deforming the metal layer along a planned dividing line (4), forming a groove extending along the planned dividing line and a protruding portion extending adjacent to the groove, and forming a crack (5) extending in a thickness direction of the semiconductor wafer along the planned dividing line by pressing a pressing member (60) against the main surface of the metal layer along the planned dividing line; and
after the forming of the crack, dividing the semiconductor wafer along the planned dividing line by pressing a dividing member (62) against the second surface of the semiconductor wafer along the planned dividing line.

9. The manufacturing method according to claim 8, wherein
the pressing member is a scribing wheel,
the pressing of the pressing member is rolling of the scribing wheel, and
the forming of the crack includes forming, on the first surface, a scribe line with the crack extending in the thickness direction of the semiconductor wafer along the planned dividing line.

10. The manufacturing method according to claim 8 or 9, wherein
the first metal layer includes at least one of a nickel layer or a titanium layer, and
the second metal layer is a gold layer.
